# EUROPÄISCHE PATENTANMELDUNG

(11) **EP 2 241 878 A2**
(43) Veröffentlichungstag der Anmeldung: **20.10.2010**
(21) Anmeldenummer: 10158562.8
(22) Anmeldetag: 31.03.2010
(51) Int. Cl.: G01N 21/956

(54) **Verfahren zur Inspektion von Lötstellen an elektrischen und elektronischen Bauteilen**

(30) Priorität: 15.04.2009 DE 102009017695
(71) Anmelder: Göpel electronic GmbH, 07745 Jena (DE)
(72) Erfinder: Sauer-Peters, Sebastian, 07743, Jena (DE)
(74) Vertreter: Oehmke, Volker

(57) **Zusammenfassung**

Die vorliegende Erfindung betrifft ein Verfahren zur Inspektion von Lötstellen an oberflächenmontierten elektrischen und elektronischen Bauteilen.

Der Erfindung liegt die Aufgabe zugrunde, eine Möglichkeit aufzuzeigen, durch die es mit möglichst geringem Aufwand gelingt, effizient fehlerbehaftete Lötstellen, z.B. an einem Pad (6), insbesondere durch ungenügende oder fehlende Benetzung der Anschlusselemente, z.B. Pinfuß (5), mit Lot, an elektrischen und elektronischen Bauteilen (1) zu detektieren.

Die Aufgabe wird mit einem Verfahren zur Inspektion von Lötstellen mittels Beleuchtung (3,4) der zu prüfenden Lötstellen, Erfassung der reflektierten Lichtanteile durch mindestens eine auf das Spektrum der zu erfassenden Wellenlängen abgestimmte Aufnahmeeinrichtung, z.B. Kamera (2) und rechnergestützte Bearbeitung und Analyse der Bilddaten gelöst.

## Beschreibung

Die vorliegende Erfindung betrifft ein Verfahren zur Inspektion von Lötstellen an oberflächenmontierten elektrischen und elektronischen Bauteilen.

Moderne elektrische, vornehmlich aber elektronische Bauteile wie integrierte Schaltkreise weisen oft eine Mehrzahl von Anschlüssen, den sogenannten Pins, auf, die zudem im Bereich von nur wenigen Zehntelmillimetern bis Millimetern voneinander beabstandet sind. Diese Bauteile werden auf einem Trägerelement, wie z. B. einer Platine, über den Pinfuß mit einer elektrisch leitfähigen, auf dem Trägerelement aufgebrachten Kontaktfläche, dem sogenannten Pad, verlötet.
Eine rein visuelle Inspektion einer solchen Vielzahl von Lötverbindungen mit sehr geringen räumlichen Ausmaßen ist sehr zeitintensiv und mit einem hohen personellen Aufwand verbunden. Es ist eine Reihe von Lösungen bekannt, die das automatisierte Auffinden von Lötfehlern mit einer geringen Irrtumswahrscheinlichkeit ermöglichen sollen.
Es können bei Lötverbindungen verschiedene Fehlerarten auftreten. So können fehlerhafte Lotmengen gut über bekannte Prüfverfahren, wie sie z. B. in der DE 35 40 288 C2 und der DE 689 07 688 T2 beschrieben sind, gefunden werden. Schwieriger zu erkennen sind dagegen mangelhafte Verbindungen, die auf eine fehlende oder ungenügende Benetzung von Pinfuß und Pad durch das Lot zurück zu führen sind. Dabei können durchaus elektrisch leitfähige Kontakte bestehen, so dass bei einer reinen Leitfähigkeitsprüfung diese Fehler nicht sofort entdeckt werden. Bei mechanischen Beanspruchungen der Bauteile, z. B. durch Stöße, Schwingungen oder bei Temperaturschwankungen treten diese Verbindungsfehler aber zu Tage. Weiterhin können einzelne Pins verbogen sein und befinden sich dadurch nicht im Bereich der Kontaktfläche mit dem Pad.
Ungenügend oder nicht verbundene Komponenten einer Lötverbindung werden nach der JP 60257227 A dadurch detektiert, dass mittels eines gerichteten Luftstromes das zu prüfenden Bauteil mechanisch belastet wird. Treten bei mangelhaften Verbindungen Vibrationen an den Lötstellen auf, können diese durch einen Laser und eine Laserdetektionseinheit festgestellt werden.
In der JP 03176654 A wird eine Prüfung von Lötstellen durch deren Erwärmung mittels Laser offenbart. Die emittierte infrarote Strahlung wird erfasst und ein Vergleich mit abgespeicherten Referenzdaten durchgeführt.
Einer ähnlichen Methodik bedienen sich die Lösungen nach den Schriften DE 42 34 121 C2 und DE 195 20 336 A1. Die Lötstelle wird mit einem Laser erwärmt. Das dabei entstehende Ultraschallsignal wird durch einen Sensor registriert und mit einem Referenzsignal verglichen.
Eine rein optische Inspektion von Lötstellen wird in der DE 35 40 288 C2 beschrieben. Dabei wird eine zu prüfende Lötstelle unter verschiedenen Winkeln beleuchtet und mehrere Bilder der Lötstelle generiert. Die Anordnung nutzt dabei das unterschiedliche Reflexionsverhalten von verschieden gewölbten Oberflächen. Die Reflexionsintensitäten werden in ein binäres Signal übersetzt und ein resultierendes Hell-Dunkel-Muster der Lötstelle generiert. Ein Abgleich dieses Musters mit in einer Datenbank hinterlegten Mustern erlaubt die Bewertung der Qualität der Lötstelle.
Die DE 41 39 189 C2 greift das Problem der Prüfung hintereinander liegender Pins eines oberflächenmontierten Bauteils auf. Auch hier werden Reflexionsunterschiede an gewölbten Oberflächen für die Beurteilung der Lötverbindungen genutzt. Es werden mehrere Schrägblickkameras und in ihrer Nähe angeordnete Lichtquellen sowie eine senkrecht angeordnete Kamera mit einer ringförmigen Beleuchtung, die in Richtung der optischen Achse der Kamera weist, beschrieben. Die Anordnung der Beleuchtungs- und Bildaufnahmeeinrichtungen erlaubt die simultane Prüfung von mehreren Pins, die sich zudem auf unterschiedlichen Seiten des Bauteils befinden können. In der DE 41 39 189 C2 werden wiederum Hell-Dunkel-Verteilungsmuster aus den erstellten Bildern gewonnen und ein Vergleich mit in einer Datenbank hinterlegten Referenzmustern angestellt. Reichen diese Informationen nicht für eine Beurteilung der Lötstelle aus, sieht die Schrift den zusätzlichen Einsatz eines Lasers vor, der dann eine dreidimensionale Beschreibung der Lötstelle erlaubt.

Den vorliegenden technischen und konzeptionellen Lösungen zur Inspektion von Lötstellen ist gemein, dass diese eine komplexe apparative Ausstattung erfordern. Zudem benötigen die Prüfungen einer Vielzahl von Lötstellen eine erhebliche Zeit, besonders dann, wenn eine Oberflächenabtastung mittels Laser vorgesehen ist. Es ist weiterhin nachteilig, dass eine Prüfung gänzlich unabhängig vom Layout der Pads des Trägerelementes nicht möglich ist.

Der Erfindung liegt die Aufgabe zugrunde, eine Möglichkeit aufzuzeigen, durch die es mit möglichst geringem Aufwand gelingt, effizient fehlerbehaftete Lötstellen, insbesondere durch ungenügende oder fehlende Benetzung der Anschlusselemente mit Lot, an elektrischen und elektronischen Bauteilen zu detektieren.

Erfindungsgemäß wird die Aufgabe durch ein Verfahren zur Inspektion von Lötstellen, insbesondere an elektrischen und elektronischen Bauteilen, mittels Beleuchtung der zu prüfenden Lötstellen zwischen rechteckig ausgeformten Pinfüßen und auf einer Trägerplatte befindlichen Pads, Erfassung der reflektierten Lichtanteile durch mindestens eine auf das Spektrum der zu erfassenden Wellenlängen abgestimmte Aufnahmeeinrichtung und rechnergestützte Bearbeitung und Analyse der Bilddaten dadurch gelöst, dass
- zunächst ein Bild, bestehend aus x_{i,j}-Bildpunkten, von der Trägerplatte mit den zu prüfenden Lötstellen generiert wird, wobei die Aufnahmeposition senkrecht zu den langen Kanten der Pinfüße und unter einem Winkel außerhalb der senkrechten zur Trägerplatte derart gewählt wird, dass alle gleich ausgerichteten Pinfüße mit ihren Lötstellen auf dem Bild erkennbar sind und während der Generierung des Bildes die Trägerplatte aus der selben Richtung der Aufnahmeposition und optional zusätzlich senkrecht beleuchtet wird,
- innerhalb des generierten Bildes ein erster rechteckiger Prüfbereich definiert wird, der sich über die sichtbare Kante des Pinfußes und der Ausdehnung des sichtbaren seitlichen Lotüberstandes der Lötstelle erstreckt,
- von allen Grauwerten der im ersten Prüfbereich befindlichen Bildpunkten der Mittelwert gebildet wird und
- der Mittelwert mit einem ersten Schwellwert verglichen wird, wobei die Lötstelle als fehlerfrei bewertet wird, wenn der Mittelwert kleiner als der Schwellwert ist.

Für den Fall, dass der Mittelwert größer als der Schwellwert ist, wird für die gerade zu prüfende Lötstelle ein orthogonal zum ersten Prüfbereich angeordneter zweiter rechteckiger Prüfbereich festgelegt, der sich höchstens über die seitliche Kante des Pinfußes und in der anderen Richtung mindestens von der Unterkante des Lotüberstandes bis zum Ende der sichtbaren Oberfläche des Pinfußes reichend erstreckt. Von allen Grauwerten der im zweiten Prüfbereich befindlichen Bildpunkten werden zeilenweise Mittelwerte gebildet und anschließend werden die Mittelwerte mit einem zweiten Schwellwert verglichen, wobei das Nichtüberschreiten oder das durch mindestens drei aufeinanderfolgende unterschreitende Mittelwerte getrennte mehrfache Überschreiten des zweiten Schwellwertes von mindestens drei aufeinanderfolgenden Mittelwerten zur Folge hat, dass die Lötstelle als fehlerhaft bewertet wird. Bei genau einmaliger Überschreitung von mindestens drei aufeinanderfolgenden Mittelwerten über den zweiten Schwellwert wird abschließend ermittelt, ob die zugehörige Zeile desjenigen Wertes, bei dem der zweite Schwellwert erstmalig überschritten wird, mit der bekannten Position der sichtbaren Kante des Pinfußes korrespondiert, so dass bei Übereinstimmung die Lötstelle als fehlerfrei, jedoch bei Nichtübereinstimmung als fehlerhaft bewertet wird.

Mit dem erfindungsgemäßen Verfahren können Lötstellen, über die elektrische und elektronische Bauteile mit weiteren Komponenten einer Schaltung in Verbindung stehen, auf ihre Qualität hin, insbesondere auf das Vorhandensein der Lötfehler mangelnder oder fehlender Benetzung von Pinfuß und/oder Pad sowie aus dem Bereich der Kontaktfläche mit dem Pad herausgebogene Pins überprüft werden. Das Wesen der Erfindung besteht darin, dass mit Hilfe der Oberflächenausprägung des Lotes, insbesondere des seitlichen Lotüberstandes einer Lötstelle, die Qualität bewertet werden kann. Während der Lotüberstand eines korrekt angeflossenen Pinfußes eine konkave Oberfläche aufweist, bildet bei mangelnder oder fehlender Benetzung der Lotüberstand eine konvexe Oberfläche, welche zu einer stärkeren Anregung der Bildpunkte einer Aufnahmeeinrichtung führt. Das Verfahren zielt insbesondere auf die zeitgleiche Prüfung einer Mehrzahl von Lötstellen eines elektrischen oder elektronischen Bauteils, wobei jede einzelne Lötstelle mittels eines Prüfungsalgorithmus bewertet wird.

Von einer zu prüfenden Lötstelle, die einen Pin mit dem zugehörigen Pad durch das aufgebrachte Lot mechanisch und elektrisch leitend verbindet, wird ein Bild, vorzugsweise eine elektronische Darstellung erzeugt. Dabei wird jedem Bildpunkt ein exakter Wert zugeordnet, der die, durch die auftreffende Strahlungsenergie hervorgerufene, Intensität dieses Bildpunktes numerisch beschreibt. Diese numerischen Werte repräsentieren die Helligkeit und damit den Grauwert eines jeden Bildpunktes. Vorzugsweise wird als Bildaufnahmeeinrichtung eine MatrixKamera verwendet, die beispielsweise mit einem CCD-Sensor oder einem CMOS-Chip bestückt ist.

Das erfindungsgemäße Verfahren ist grundsätzlich auch auf Bilder anwendbar, die nicht in digitalisierter Form vorliegen und nachträglich digitalisiert werden.

In einer für die Anwendung des erfindungsgemäßen Verfahrens geeigneten Anordnung wird mindestens eine Lötstelle eines elektrischen oder elektronischen Bauteils durch eine erste Beleuchtungseinrichtung aus der Aufnahmerichtung einer Kamera angestrahlt. Eine solche Anordnung kann beispielsweise durch eine Kamera und eine um die optische Achse der Kamera angeordnete ringförmige Lichtquelle geschaffen werden.

In weiteren vorteilhaften Ausführungen sind eine oder mehrere Leuchtquellen in der Nähe der Kamera angeordnet. Diejenigen Strahlen, die auf senkrecht zur Beleuchtungseinrichtung stehenden Oberflächen auftreffen, werden entlang oder nahe der optischen Achse der Kamera reflektiert und können durch diese erfasst werden. Dabei führen senkrecht reflektierte Strahlen zu einer starken Anregung der Bildpunkte und damit zu hohen Intensitätswerten dieser Strahlen, die auf geneigte Oberflächen des beleuchteten Körpers auftreffen, werden unterschiedlich stark abgelenkt. Das mittels der Kamera erzeugte Bild weist entsprechend der Orientierungen der dargestellten Oberflächen Bereiche mit verschiedenen Intensitätswerten auf.

Die der Beleuchtungseinrichtung und der Kamera entgegengerichteten Oberflächen können beispielsweise Kanten des Pinfußes oder gewölbte, insbesondere konvexe Oberflächen sein.

Beleuchtungseinrichtung und Kamera werden senkrecht zu der zu prüfenden Seite der Lötverbindung und unter einem Winkel außerhalb der Senkrechten zur Trägerplatte angeordnet. Sollten mehrere hintereinanderliegende Lötstellen mit einem Bild geprüft werden, so wird der Winkel derart gewählt, dass alle, oder zumindest eine möglichst große Anzahl der zu prüfenden Lötstellen weitestgehend ohne Verdeckungen sichtbar sind.

Eine Prüfanordnung, bei der die zu prüfenden Lötstellen von seitlich oben beleuchtet und abgebildet werden, hat gegenüber Anordnungen mit senkrecht oberhalb der Prüflinge angeordneter Kamera und/oder Beleuchtung den Vorteil, auch bei sehr geringen Unterschieden in der flächenhaften Ausdehnung der Kontaktflächen von Pinfuß und Pad anwendbar zu sein. Zudem können Lötstellen geprüft werden, die von senkrecht oben ganz oder teilweise vom Pinfuß überdeckt sind.

Die optischen Kennwerte und die Objektivanordnung der Kamera werden dabei so gewählt, dass trotz eines großen zu messenden Betrachtungsfeldes eine scharfe Abbildung gewährleistet wird. Bei entsprechend großem Betrachtungsfeld ist die gleichzeitige Erfassung von auf den entgegengesetzten Seiten von Bauteilen geeigneter Größe befindlicher Lötstellen möglich.

Werden elektrische oder elektronische Bauteile geprüft, die an mehreren Seiten austretende Pins und damit zu prüfende Lötstellen aufweisen, werden von diesen Bauteilen jeweils von jeder Seite, soweit sie sich nicht nur gegenüberliegen, Bilder aufgenommen.

Dafür können mehrere Kameras und Beleuchtungen oder aber nur eine dreh- und/oder schwenkbare und/oder in ihrer relativen Position zum zu prüfenden Bauteil veränderlichen Kamera und Beleuchtung eingesetzt werden.

Sobald nicht alle zu prüfenden Lötstellen mit einem Bild erfassbar sind, werden Beleuchtungseinrichtung und Kamera und/oder zu prüfendes Bauteil relativ zueinander so bewegt, so dass für alle relevanten Zustände auszuwertende Bilder generiert werden.

Durch die Kamera wird von dem zu prüfenden elektrischen oder elektronischen Bauteil mindestens ein Bild aufgenommen. Die Bilddaten werden einer Rechnereinheit zugeführt.

Es ist für Kontrollzwecke vorteilhaft, das gewonnene Bild über ein geeignetes Verfahren und eine Vorrichtung visuell wahrnehmbar darzustellen.

In einer vorteilhaften Ausführung werden die Grauwerte einer linear von 0 (Weiß) bis 255 (Schwarz) reichenden Skala eines 8-bit-Grauwertbildes den Intensitätswerten der Bildpunkte zugeordnet. Der erste Schwellwert beträgt dann z. B. mindestens 80 und der zweite Schwellwert 150.

Es ist für die Auswertung des zweiten Prüfbereiches von größtem Vorteil, wenn die zu prüfende Lötstelle durch mindestens eine weitere Beleuchtungseinrichtung von oben senkrecht beleuchtet wird. Strahlungsanteile aus der senkrechten Beleuchtung werden nach dem Auftreffen auf die Lötstelle unter anderem in Richtung der Kameraachse reflektiert und erhöhen dadurch die Sensitivität der Prüfanordnung.

Eine Definition der beiden Prüfbereiche kann sowohl manuell als auch automatisiert erfolgen. Außerdem können die Prüfbereiche für eine Lötstelle gleichzeitig festgelegt werden. Der zweite Prüfbereich kann aber auch erst dann definiert werden, wenn es bei der Auswertung des ersten Prüfbereiches zu einer Schwellwertüberschreitung kam.

In einer vorteilhaften Weiterentwicklung werden diejenigen Reflexionen als Referenzbereiche für eine automatisierte Detektion der Lötstellen und der Festlegung der Prüfbereiche verwendet, die durch eine senkrecht von oben erfolgende Beleuchtung hervorgerufen werden und die eine bestimmte Lagebeziehung zur zugehörigen Lötstelle haben. Beispielsweise kann eine als Referenz verwendete Reflexion der Pin-Schulter erfasst werden. Die Zuordnung von Referenzbereich und zugehöriger Lötstelle erfolgt über deren vorbekannten geometrischen Beziehungen zueinander sowie unter Berücksichtigung der Ausprägungen dieser Beziehungen in der zweidimensionalen Abbildung.
Solche Referenzbereiche sind vorteilhaft so gewählt, dass diese ein einheitliches Erscheinungsbild aufweisen und von der Lötstelle so beabstandet sind, dass von der Lötstelle ausgehende Reflexionen die Nutzbarkeit der Referenzbereiche nicht beeinträchtigen.

In vorteilhaften Weiterentwicklungen der Erfindung können die Werte der Bildpunkte durch die Beleuchtung mit für den jeweilig zu erfassenden Parameter günstigen Wellenlängen oder Spektren, wie z. B. ultraviolettes Licht oder InfrarotStrahlung beaufschlagt werden.

Die für die Prüfbereiche festgelegten Schwellwerte sind voneinander unabhängig. Werden mehrere Lötstellen gleichzeitig geprüft, können die Schwellwerte für jede Lötstelle einzeln festgelegt werden. Damit kann den möglicherweise unterschiedlichen Reflexionsverhältnissen der einzelnen Lötstellen Rechnung getragen werden.

In weiterführenden Ausgestaltungen der Erfindung können die Positionen der gefundenen Fehlerstellen der jeweiligen Bauteile abgespeichert werden, um diese Bauteile ganz gezielt nacharbeiten zu können.

Die Schritte des erfindungsgemäßen Verfahrens wie z. B. der Bildaufnahme, Definition der Prüfbereiche, Erstellung eines Intensitätsprofils, dessen Auswertung und Entscheidung über die Erfüllung bzw. Nichterfüllung der Prüfkriterien können bei wiederkehrender Prüfung eines Bauteils oder eines Bauteiltyps z. B. unter Nutzung einer Datenbank automatisiert werden. In einer solchen Datenbank können verschiedene Ausprägungen der Intensitätsprofile und deren Bewertungskriterien abgespeichert und bei Bedarf abgerufen werden.

Es kann weiterhin Bestandteil des Analysealgorithmus sein, Durchbiegungen der Oberfläche des Trägerelementes zu erfassen und durch eine geeignete Korrekturfunktion bei der Analyse der Lötstellen in Anhängigkeit deren Lage auf dem Trägerelement auszugleichen.

Das erfindungsgemäße Verfahren erlaubt die automatische optische Inspektion von Lötstellen. Ein senkrecht zu einer zu prüfenden Seite einer Verbindung und ggf. unter einem bestimmten Winkel von der Horizontalen aufgenommenes Bild wird digital abgespeichert, wobei jedem Bildpunkt ein Wert zugeordnet wird, der den Grauwert des betreffenden Bildpunktes angibt. Jeder abgebildeten Lötstelle werden zwei Prüfbereiche zugeordnet. Der ersten Prüfbereich dient der Detektion starker Reflexionen im Bereich des Lotüberstandes während der zweite Prüfbereich die Anzahl der vorhandenen reflektierenden Oberflächen ermitteln lässt. Den Prüfbereichen werden Schwellwerte zugewiesen, anhand deren Unter- oder Überschreitung Entscheidungen über die Qualität der Lötstelle oder weiterer Prüfschritte gefällt werden.

Die Erfindung soll nachstehend anhand von Ausführungsbeispielen näher erläutert.
Es zeigen die dazugehörigen Zeichnungen:
- Fig. 1: schematische Darstellung der Prüfanordnung
- Fig. 2a: schematische Darstellung der Strahlenverläufe an einem benetzten Pin
- Fig. 2b: schematische Darstellung der Strahlenverläufe an einem nicht benetzten Pin
- Fig. 3: Prinzipdarstellung einer Lötstelle und Lage der Prüfbereiche in der Seitenansicht
- Fig. 4: Darstellung einer Profilfunktion bei korrekter Lötstelle
- Fig. 5: Darstellung einer Profilfunktion bei fehlerhafter Lötstelle
- Fig. 6: eine weitere Darstellung einer Profilfunktion einer korrekten Lötstelle
- Fig. 7: Schema des erfindungsgemäßen Verfahrens

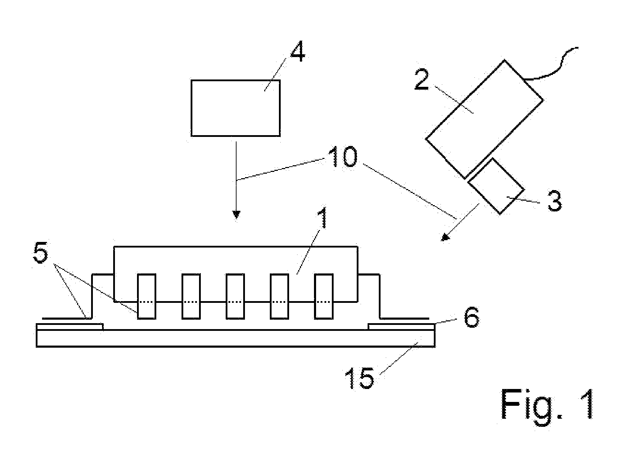

Gemäß Fig. 1 befindet sich auf einer Trägerplatte 15 ein Bauteil 1, das an allen seiner vier Seiten Pins aufweist. Das Bauteil 1 ist über flächenhaft ausgeformte Kontaktbereiche der Pins, den Pinfüßen 5 mittels Lot mechanisch und elektrisch leitend mit flächenhaften ausgebildeten Kontaktbereichen von Leiterbahnen, den Pads 6, verbunden. Die Leiterbahnen und Pads 6 sind auf der Oberfläche der Trägerplatte 15 aufgebracht.

Die Pins des Bauteils 1 sind gemäß Fig. 1 als sogenannte Gullwing-Pins ausgebildet, deren Pinfüße 5 einen rechteckigen Querschnitt aufweisen. Jeder Pinfuß 5 ist derart geformt, dass die flächenhafte Ausdehnung des Pinfußes 5 durch eine Kante zur Stirnseite und zwei zueinander parallele Längskanten zu den Seitenflächen begrenzt wird. Der dem Bauteil 1 zugewandte, sich an den Pinfuß 5 anschließenden Teil des Pins, der Pinanstieg, hebt sich von dem Pad 6 ab und führt zum Bauteil 1, wo über die Pinschulter der Kontakt zum Bauteil 1 hergestellt wird. Im montierten Zustand verlaufen die Pinfüße 5 und damit die Längskanten parallel zur Oberfläche des Pads 6 und der Trägerplatte 15.

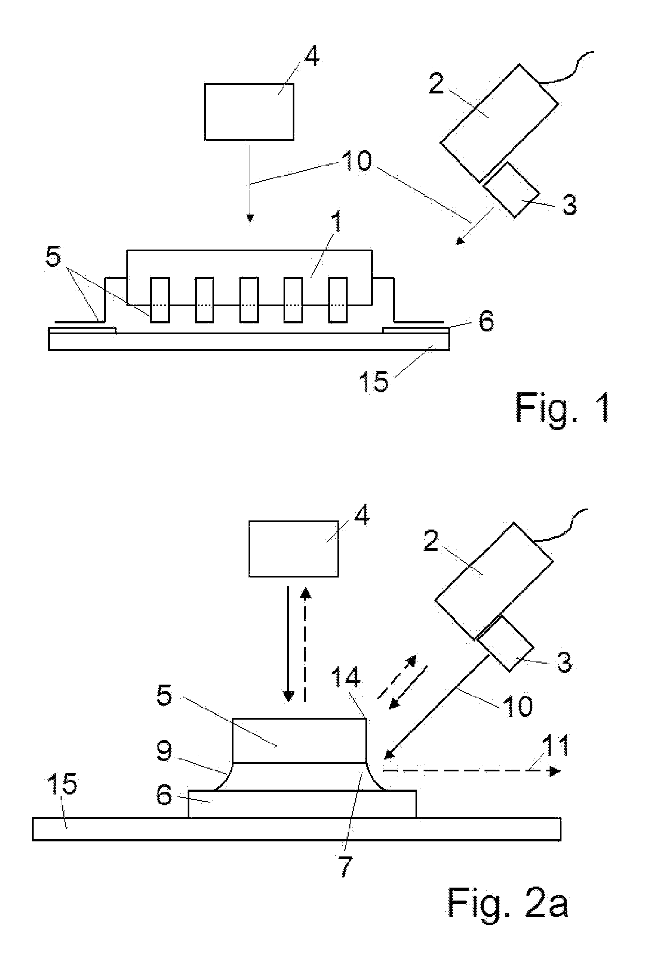

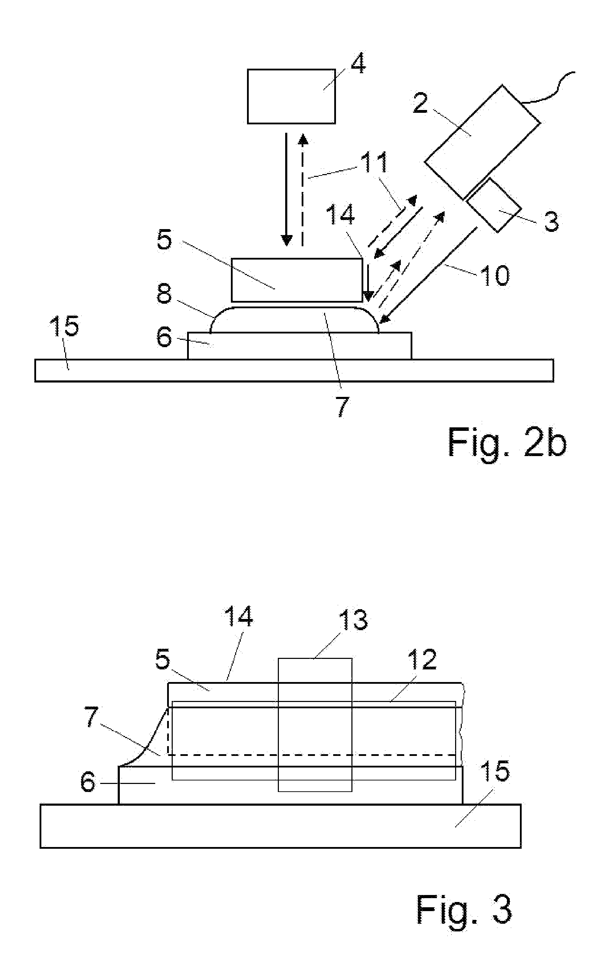

Senkrecht zu einer der Längskanten des Pinfußes 5 und unter einem Winkel von 45° bezogen auf die Trägerplatte 15, ist eine Kamera 2 und eine seitliche Beleuchtungseinrichtung 3 angeordnet. Der Winkel kann in weiteren Ausführungen der Erfindung so verändert werden, dass bei mehreren, hintereinander in Reihe angeordneten Lötstellen möglichst wenige durch davor befindliche Lötstellen oder andere Elemente verdeckt werden. Die Anordnung der Kamera 2 und der seitlichen Beleuchtungseinrichtung 3 ermöglicht eine Bildaufnahme von allen Lötstellen, die sich auf den gegenüberliegenden Seiten des Bauteils 1 befinden. Über dem Bauteil 1 befindet sich eine senkrechte Beleuchtungseinrichtung 4. Der einfallende Strahl 10 der seitlichen Beleuchtungseinrichtung 3 ist dabei hauptsächlich auf die Lötstellen gerichtet während die senkrechte Beleuchtungseinrichtung 4 das Bauteil 1 und die umgebenden Bereiche der Trägerplatte 15 anstrahlt.
Die für den Kontakt mit dem Pin zur Verfügung stehende Oberfläche des Pads 6 ist nicht kleiner als die kontaktierende Oberfläche des Pinfußes 5. Das Lot befindet sich zwischen Pinfuß 5 und Pad 6 und weist einen seitlichen Lotüberstand 7 entweder gemäß Fig. 2a oder Fig. 2b auf. Die Elemente Pinfuß 5, Pad 6 und der durch das Lot gebildete Lotüberstand 7 stellen die zu prüfende Lötstelle dar.

In weiteren Ausführungen der Erfindung kann die seitliche Beleuchtungseinrichtung 3 aus einer oder mehreren, um oder nahe der optischen Achse der Kamera 2 befindlichen Lichtquellen bestehen.

Um Bilder von den an den angrenzenden Seiten eines Bauteils 1 befindlichen Pinfüßen 5 generieren zu können, sind in einer ersten Ausführung zwei Kameras 2 mit je einer seitlichen Beleuchtungseinrichtung 3 so angeordnet, das ihre Aufnahmerichtungen um 90° zueinander versetzt sind. Jede der Kameras 2 erfasst somit jeweils die hälftige Anzahl der zu prüfenden Lötstellen des Bauteils 1.

In einer weiteren Ausgestaltungsmöglichkeit ist die Kamera 2 um 360° drehbar und/oder in ihrer Lage relativ zu den zu prüfenden Lötstellen veränderbar. Dadurch können nacheinander mindestens zwei, in ihrer Aufnahmerichtung um etwa 90° versetzte, Bilder so aufgenommen werden, dass alle Lötstellen eines Bauteils 1 durch die Kamera 2 erfasst werden.

Die Kamera 2 ist eine digitale CCD-Kamera mit einem Betrachtungsfeld von 42x42 mm und einer Auflösung von 10,5 µm / Bildpunkt. Die Abstimmung zwischen Objektiv und CCD-Sensor erfolgt durch Einstellung des entsprechenden Scheimpflugwinkels derart, dass über das ganze Betrachtungsfeld eine hohe Tiefenschärfe gegeben ist. Das aufgenommene Bild besteht also aus einzelnen Bildpunkten xᵢⱼ mit i-Zeilen und j-Spalten.

Die von den beiden Beleuchtungseinrichtungen 3, 4 ausgesandten Wellenlängen oder Spektren, sind auf die Erfordernisse der CCD-Kamera 2 zur Bildaufnahme abgestimmt.

In einem ersten Schritt wird durch die Kamera 2 ein Bild der Lötstelle generiert. Treffen die einfallenden Strahlen 10 der Beleuchtungsquellen 3, 4 auf die zu prüfende Lötstelle, so werden diese Strahlen 10 bei korrektem Anfluss des Lotes an Pad 6 und Pinfuß 5 durch die konkave Oberfläche 9 des Lotüberstandes 7 gemäß der Fig. 2a als reflektierter Strahl 11 zurückgeworfen. Bereiche der einen sichtbaren Längskante, der Kante 14 des Pinfußes 5, stehen der Kamera 2 senkrecht gegenüber, die als heller Bereich im Bild wiedergegeben wird. Hat sich ein Lötdepot mit einer konvexen Oberfläche 8 gebildet, so erreichen gemäß Fig. 2b eine größere Quantität an zusätzlichen, direkt reflektierten Strahlen 11 die Kamera 2, was zu hohen Intensitätswerten in weiteren Bildpunkten führt.

Durch die Kamera 2 wird ein zweidimensionales Bild von dem Bauteil 1 aufgenommenen, abgespeichert und auf dem Monitor eines Rechners (beide nicht gezeigt) dargestellt. Mittels einer auf dem Rechner installierten geeigneten Software werden die rechteckigen ersten und zweiten Prüfbereiche 12, 13 für jede der mittels des aufgenommenen Bildes zu prüfenden Lötstellen des Bauteils 1 in ihrer Lage und Ausdehnung manuell festgelegt.

Beide Prüfbereiche 12, 13 bestehen aus in Zeilen und Spalten angeordneten Bildpunkten. Beide Prüfbereiche 12, 13 überschneiden sich gemäß Fig. 3 teilweise im Bereich des Lotüberstandes. Der erste Prüfbereich 12 ist dadurch festgelegt, dass sich sämtliche Zeilen des ersten Prüfbereiches 12 über höchstens die Länge der sichtbaren seitlichen Kante 14, sämtliche Spalten höchstens über den sichtbaren seitlichen Lotüberstand 7 erstrecken. Der zweite Prüfbereich 13 überschneidet sich teilweise mit dem ersten Prüfbereich 12 im Bereich des Lotüberstandes 7. Der zweite Prüfbereich 13 ist dadurch festgelegt, dass sich dessen sämtliche Zeilen über höchstens alle Spalten des ersten Prüfbereiches 12 erstrecken und dessen Spaltenlänge so lang ist, dass neben dem seitlichen Lotüberstand 7 mindestens auch die sichtbare Oberfläche des Pinfußes 5 im zweiten Prüfbereich 13 liegt (Fig. 3).

Es ist für die weiter unten erläuterte visuelle Auswertung der aus dem zweiten Prüfbereich 13 gewonnen Informationen von Vorteil, wenn sich der zweite Prüfbereich 13 über die Abbildung der Kante 14 hinaus erstreckt. Allerdings dürfen dabei keinesfalls Bereiche benachbarter Lötstellen oder auch nur von diesen verursachte Reflexionen in dem zweiten Prüfbereich 13 enthalten sein. In diesen Fällen ist die Ausdehnung des zweiten Prüfbereiches 13 entsprechend anzupassen.

Beide Prüfbereiche 12, 13 werden in unmittelbar aufeinander folgenden Verfahrensschritten festgelegt. Es ist in einer weiteren Ausführung der Erfindung auch möglich, den zweiten Prüfbereich 13 erst dann festzulegen, wenn die Auswertung des ersten Prüfbereiches 12 eine fehlerhafte Lötstelle anzeigt.

In einem ersten Prüfschritt wird über alle Grauwerte des ersten Prüfbereiches 12 ein Mittelwert X1 gebildet und abgespeichert. Dieser wird mit einem ersten Schwellwert S1 verglichen, der auf einer Skala von 0 bis 255 Grauwertstufen den Wert 80 hat. Wird selbst dieser vergleichsweise geringe Helligkeitswert nicht erreicht, liegt keine starke Reflexion im Bereich des Lotüberstandes 7 vor und die Lötstelle wird als fehlerfrei bewertet.

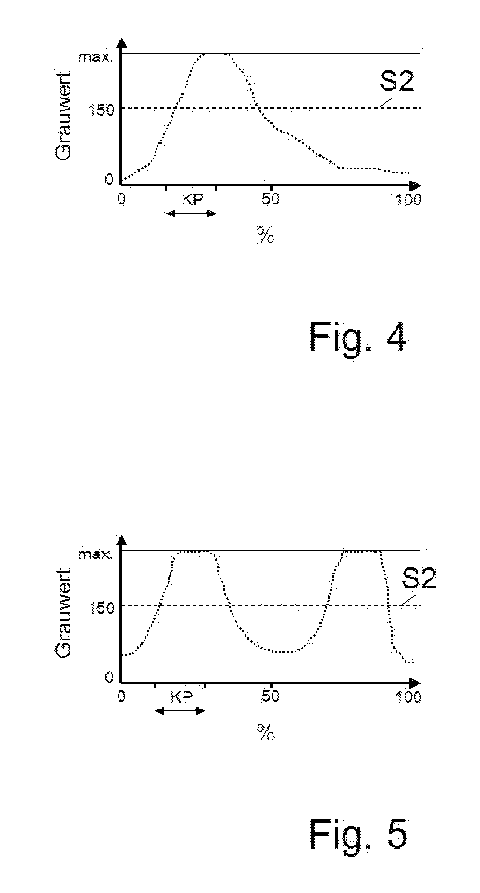

Wird in einem solchen Fall ein Grauwertprofil aus dem zweiten Prüfbereich 13 abgeleitet, zeigt dieses gemäß Fig. 4 keine nennenswerten Reflexionen in der mit dem Lötüberstand 7 korrespondierenden rechten Hälfte des Graphen.

Tritt eine Überschreitung des ersten Schwellwertes S1 in dem ersten Prüfbereich 12 auf, kann geprüft werden, ob es sich nicht trotzdem um eine fehlerfreie Lötstelle handelt.

Dazu wird über jede Zeile i des zweiten Prüfbereiches 13 von der zu prüfenden Lötstelle ein Mittelwert X2ᵢ errechnet und in der Form eines einspaltigen Vektors abgespeichert. Jeder Wert X2ᵢ repräsentiert einen Grauwert auf einer linearen, von 0 (schwarz) bis 255 (weiß) reichenden Skala eines 8-bit Grauwertbildes. Die Grauwerte werden in einem kartesischen Koordinatensystem über der Abfolge der Zeilen aufgetragen. Die gesamte Länge der x-Achse wird auf 100% standardisiert.

Überschreiten gemäß der Fig. 4, 5, 6 mindestens drei aufeinander folgende Werte X2ᵢ einen zweiten Schwellwert S2 von 150, wird ein Zählsignal generiert und die Anzahl der Zählsignale Z abgespeichert. Eine neuerliche Überschreitung des zweiten Schwellwertes S2 liegt vor, wenn zwischen den Schwellwertüberschreitungen mindestens drei aufeinander folgende Werte X2ᵢ den zweiten Schwellwert S2 unterschritten hatten. Aus dem Verlauf der X2ᵢ-Werte nach Fig. 5 ergibt sich eine Anzahl der Zählsignale Z von 2. Die Anzahl der Zählsignale Z wird mit der Anzahl der Kanten K verglichen, die im zweiten Prüfbereich 13 vorhandenen und der Kamera 2 entgegen gerichtet sind. Im Beispiel beträgt die Anzahl der Kanten K = 1. Es wurden mehr reflektierende Oberflächen detektiert als Kanten 14 im zweiten Prüfbereich 13 vorhanden sind.

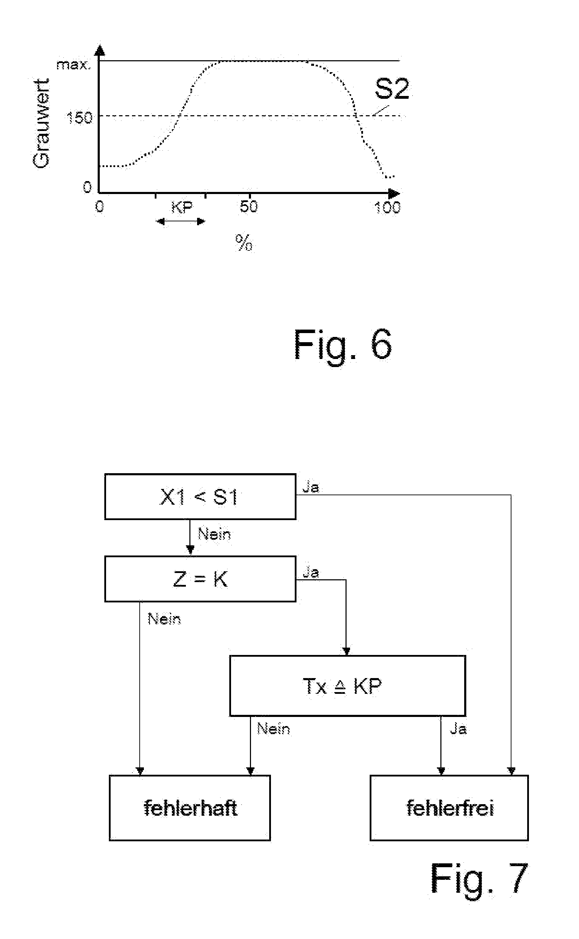

Die Lötstelle ist daher gemäß dem Entscheidungsalgorithmus nach Fig. 7 fehlerhaft.

Eine weitere Ausführungsmöglichkeit sieht die Kontrolle und gegebenenfalls die Korrektur der Positionierung des zweiten Prüfbereiches 13 vor. Wird der zweite Schwellwert S2 durch mindestens drei aufeinander folgende Werte X2ᵢ überschritten und führt diese Überschreitung in der Folge nicht in den Bereich der Sättigung von mindestens einen Grauwert von 254, so wird die Positionierung des zweiten Prüfbereiches 13 verändert. Dabei kann zum einen die Anzahl der vom zweiten Prüfbereich 13 umfassten Spalten bis auf minimal zwei reduziert werden. Zum anderen kann der zweite Prüfbereich 13 innerhalb des Überschneidungsbereiches mit dem ersten Prüfbereich 12 so verschoben werden, dass der zweite Prüfbereich 13 keine Spalten beinhaltet, die nicht auch im ersten Prüfbereich 12 enthalten sind. Beide Maßnahmen können auch kombiniert werden. Kommt es durch eine solche Spaltenreduzierung und/oder Verschiebung an einer Position zur Überschreitung des Schwellwertes S2 von 254, gilt diese dann als Prüfposition.

Stimmt die Anzahl der Zählsignale Z mit der Anzahl der Kanten K überein, ist ferner zu prüfen, ob die Schwellwertüberschreitung in einem Teilabschnitt Tx entlang der x-Achse erfolgt, der mit einer Kante 14 korrespondiert.

Dies geschieht dadurch, dass ein Bereich von Zeilen definiert wird, in dem sich die Kante 14 befindet. Es wird geprüft, ob diejenige Zeile, deren X2ᵢ-Wert erstmalig den Schwellwert S2 überschreitet, innerhalb des Bereiches der Position KP der Kante 14 liegt. Ist die Prüfung zu bejahen, wird die Lötstelle als fehlerfrei erkannt. Liegt eine Verneinung vor, ist die Lötstelle endgültig fehlerhaft.

In einer weiteren Ausführung der Erfindung stehen die Spaltenlängen des zweiten Prüfbereiches 13 in einem definierten Verhältnis zu den Positionen von Lotüberstand 7 und Kante 14. Dabei ist es günstig, wenn die Spalten des zweiten Prüfbereiches 13 je ein Drittel mehr Bildpunkte enthalten als die Anzahl von Zeilen zwischen der Unterkante des Lotüberstandes 7 und der Kante 14. Dadurch wird erreicht, dass das Signal der Kante 14 in dem zu erstellenden Grauwertprofil nicht später als nach etwa 25% der x-Achse auftritt. Ein durch an einer möglicherweise vorhandenen konvexen Oberfläche 8 einer fehlerhaften Lötstelle reflektierte Strahlen 11 hervorgerufener Anstieg der Grauwerte tritt dann erst in der zweiten Hälfte des Grauwertprofils auf. Es ist dann nur zur prüfen, ob Überschreitungen vom zweiten Schwellwert S2 unterhalb und/oder oberhalb der 50%-Marke der x-Achse auftreten. Mit diesem Vorgehen kann eine zeilenbezogene Festlegung eines Bereiches der Position KP der Kante 14 umgangen werden.

Treten eine oder mehrere Überschreitungen vom zweiten Schwellwert S2 des Intensitätsprofils gemäß Fig. 5 in Teilabschnitten Tx entlang der x-Achse auf, die nicht mit der Position KP von Kanten 14 im zweiten Prüfbereich 13 korrespondieren, so stammen die Überschreitung(-en) von unerwünschten, reflektierenden Oberflächen und die Lötstelle ist fehlerhaft.

Ein Intensitätsprofil gemäß Fig. 6 zeigt eine als korrekt bewertete Lötstelle, bei der die Überschreitung vom zweiten Schwellwert S2 der Kante 14 und des Lotüberstandes 7 ineinander übergehen. Ein solches Profil kann erhalten werden, wenn der Lotüberstand 7 bedingt durch Beleuchtungswinkel und geometrische Verhältnisse der Lötstelle eine starke Reflexion in Richtung der Kamera 2 zeigt.

Eine korrekte Lötstelle wird gemäß Fig. 7 erkannt, wenn der Mittelwert X1 des ersten Prüfbereiches 12 kleiner als der zugewiesene erste Schwellwert S1 ist oder wenn der Mittelwert X1 des ersten Prüfbereiches 12 nicht kleiner als der zugewiesene erste Schwellwert S1 ist, jedoch die Anzahl der Kanten K, die der seitlichen Beleuchtungs- und Aufnahmeeinrichtung entgegenstehen, gleich der Anzahl der Zählsignale Z ist und sich zudem jede Überschreitung des Schwellwertes S2 in einem Teilabschnitt Tx der x-Achse des Intensitätsprofils befindet, der mit der Position KP der mindestens einen Kante 14 korrespondiert.

In einer weiteren Ausgestaltungsmöglichkeit können die Prüfbereiche 12 und 13 automatisiert festgelegt werden, wenn die entsprechenden Parameter für deren Festlegung in einer Datenbank (nicht dargestellt) und/oder einem Entscheidungsalgorithmus zur Verfügung gestellt werden. Als Referenzpunkte dienen durch die senkrechte Beleuchtungseinrichtung 4 hervorgerufene Reflexionen an den Oberflächen der Pinschultern, mit deren Hilfe und unter Berücksichtigung der bekannten Pingeometrie und Anordnung an dem Bauteil 1 der jeweils erste und zweite Prüfbereich 12, 13 in den Bildern definiert und einer Lötstelle zugeordnet werden kann.

Die Vorteile der Erfindung liegen in der Möglichkeit, in sehr kurzer Zeit mit geringer apparativen Ausstattung eine Vielzahl von Lötverbindungen an elektrischen oder elektronischen Bauteilen auf vorhandene Lötfehler automatisiert und mit geringen Fehlerraten optisch zu überprüfen. Dabei werden insbesondere nicht oder ungenügend benetzte Pinfüße 5 und Pads 6 aufgrund des Auftretens von fehlerhafte Lötstellen kennzeichnende Grauwertverteilungen erkannt. Das Verfahren erlaubt ein gleichzeitiges Prüfen mehrerer Lötstellen. Es können zeitgleich auch die sich auf gegenüberliegenden Seiten eines elektrischen oder elektronischen Bauteils 1 befindlichen Lötstellen geprüft werden. Das Verfahren kann in der Qualitätssicherung bei der Produktion und Bestückung von Leiterplatten und Schaltkreisen sowie bei der Inspektion und Fehlersuche bereits in Betrieb befindlicher Bauteile 1 eingesetzt werden.

### Bezugszeichenliste

- 1: Bauteil
- 2: Kamera
- 3: seitliche Beleuchtungseinrichtung
- 4: senkrechte Beleuchtungseinrichtung
- 5: Pinfuß
- 6: Pad
- 7: Lotüberstand
- 8: konvexe Oberfläche
- 9: konkave Oberfläche
- 10: einfallender Strahl
- 11: reflektierter Strahl
- 12: erster Prüfbereich
- 13: zweiter Prüfbereich
- 14: Kante
- 15: Trägerplatte
- X1: Mittelwert
- S1: erster Schwellwert
- X2ᵢ: Mittelwerte
- S2: zweiter Schwellwert
- K: Anzahl der Kanten
- Tx: Teilabschnitt
- KP: Position (der Kante 14)
- Z: Anzahl der Zählsignale

## Patentansprüche

1. Verfahren zur Inspektion von Lötstellen, insbesondere an elektrischen und elektronischen Bauteilen, mittels Beleuchtung der zu prüfenden Lötstellen zwischen rechteckig ausgeformten Pinfüßen und auf einer Trägerplatte befindlichen Pads, Erfassung der reflektierten Lichtanteile durch mindestens eine auf das Spektrum der zu erfassenden Wellenlängen abgestimmte Aufnahmeeinrichtung und rechnergestützte Bearbeitung und Analyse der Bilddaten, **dadurch gekennzeichnet, dass**
- zunächst ein Bild, bestehend aus x_{i,j}-Bildpunkten, von der Trägerplatte (15) mit den zu prüfenden Lötstellen generiert wird, wobei die Aufnahmeposition senkrecht zu den langen Kanten (14) der Pinfüße (5) und unter einem Winkel außerhalb der senkrechten zur Trägerplatte (15) derart gewählt wird, dass alle gleich ausgerichteten Pinfüße (5) mit ihren Lötstellen auf dem Bild erkennbar sind und während der Generierung des Bildes die Trägerplatte (15) aus der selben Richtung der Aufnahmeposition und optional zusätzlich senkrecht beleuchtet wird,
- innerhalb des generierten Bildes ein erster rechteckiger Prüfbereich (12) definiert wird, der sich über die sichtbare Kante (14) des Pinfußes (5) und der Ausdehnung des sichtbaren seitlichen Lotüberstandes (7) der Lötstelle erstreckt,
- von allen Grauwerten der im ersten Prüfbereich (12) befindlichen Bildpunkten der Mittelwert (X1) gebildet wird und
- der Mittelwert (X1) mit einem ersten Schwellwert (S1) verglichen wird, wobei die Lötstelle als fehlerfrei bewertet wird, wenn der Mittelwert (X1) kleiner als der erste Schwellwert (S1) ist.

2. Verfahren nach Anspruch 1, **dadurch gekennzeichnet, dass**
- für den Fall, dass der Mittelwert (X1) größer als der erste Schwellwert (S1) ist, wird für die gerade zu prüfende Lötstelle ein orthogonal zum ersten Prüfbereich (12) angeordneter zweiter rechteckiger Prüfbereich (13) festgelegt, der sich höchstens über die Kante (14) des Pinfußes (5) und in der anderen Richtung mindestens von der Unterkante des Lotüberstandes (7) bis zum Ende der sichtbaren Oberfläche des Pinfußes (5) reichend erstreckt,
- von allen Grauwerten der im zweiten Prüfbereich (13) befindlichen Bildpunkten zeilenweise Mittelwerte (X2ᵢ) gebildet werden und
- die Mittelwerte (X2ᵢ) mit einem zweiten Schwellwert (S2) verglichen werden, wobei das Nichtüberschreiten oder das durch mindestens drei aufeinanderfolgende unterschreitende Mittelwerte (X2ᵢ) getrennte mehrfache Überschreiten des zweiten Schwellwertes (S2) von mindestens drei aufeinanderfolgenden Mittelwerten (X2ᵢ) zur Folge hat, dass die Lötstelle als fehlerhaft bewertet wird.

3. Verfahren nach Anspruch 2, **dadurch gekennzeichnet, dass**
bei genau einmaliger Überschreitung von mindestens drei aufeinanderfolgenden Mittelwerten (X2ᵢ) über den zweiten Schwellwert (S2) ermittelt wird, ob die zugehörige Zeile desjenigen Mittelwertes (X2ᵢ), bei dem der zweite Schwellwert (S2) erstmalig überschritten wird, mit der bekannten Position der sichtbaren Kante (14) des Pinfußes (5) korrespondiert, so dass bei Übereinstimmung die Lötstelle als fehlerfrei, jedoch bei Nichtübereinstimmung als fehlerhaft bewertet wird.

4. Verfahren nach Anspruch 1, **dadurch gekennzeichnet, dass** das Bild als 8-bit-Grauwertbild aufgenommen wird.

5. Verfahren nach Anspruch 1 und 4, **dadurch gekennzeichnet, dass** der erste Schwellwert (S1) mit einen Wert um 80 festgelegt wird.

6. Verfahren nach Anspruch 2 und 4, **dadurch gekennzeichnet, dass** der zweite Schwellwert (S2) mit einen Wert um 150 festgelegt wird.

7. Verfahren nach Anspruch 6, **dadurch gekennzeichnet, dass** der zweite Schwellwert (S2) durch Reduzierung bis auf minimal zwei Spalten und/oder Verschiebung des zweiten Prüfbereiches (13) bis auf maximal 255 erhöht werden kann, wobei die Verschiebung des zweiten Prüfbereiches (13) nur so erfolgen darf, dass alle enthaltenen Spalten auch in dem ersten Prüfbereich (12) enthalten sind.

8. Verfahren nach einem der vorhergehenden Ansprüche, **dadurch gekennzeichnet, dass** die Prüfbereiche (12, 13) jeder Lötstelle zeitlich unmittelbar nacheinander festgelegt werden.

9. Verfahren nach Anspruch 1, **dadurch gekennzeichnet, dass** die Bildaufnahme unter einem Winkel von 45° erfolgt.

10. Verfahren nach Anspruch 1, **dadurch gekennzeichnet, dass** jeweils nur die auf einer Seite eines elektrischen oder elektronischen Bauteils (1) befindlichen Lötstellen aufgenommen werden.

11. Verfahren nach Anspruch 1, **dadurch gekennzeichnet, dass** immer alle Lötstellen von auf einer Trägerplatte (15) parallel angeordneten Pins aufgenommen werden.

12. Verfahren nach Anspruch 11, **dadurch gekennzeichnet, dass** sich die aufgenommenen Lötstellen an einer oder an entgegengesetzten Seiten eines elektrischen oder elektronischen Bauteils (1) befinden.

13. Verfahren nach einem der vorhergehenden Ansprüchen, **dadurch gekennzeichnet, dass** eine schwenkbare und/oder drehbare Beleuchtungs- und Aufnahmeeinrichtung die unterschiedlich angeordneten, zu prüfenden Lötstellen aus verschiedenen Richtungen erfasst.
